Europäisches Patentamt

European Patent Office

Office européen des brevets

(19)

(11) Numéro de publication: **0 128 791**
A1

# (12) DEMANDE DE BREVET EUROPEEN

(21) Numéro de dépôt: **84400963.9**

(22) Date de dépôt: **11.05.84**

(51) Int. Cl.³: **F 42 D 1/04**, G 01 R 17/10

---

(30) Priorité: **11.05.83 FR 8307889**

(43) Date de publication de la demande: **19.12.84**
**Bulletin 84/51**

(84) Etats contractants désignés: **AT DE GB SE**

(71) Demandeur: **Puntous, René, 48, Rue Pernety, F-75014 Paris (FR)**

(72) Inventeur: **Puntous, René, 48, Rue Pernety, F-75014 Paris (FR)**

(74) Mandataire: **Laget, Jean-Loup et al, Cabinet Pierre Loyer 18, Rue de Mogador, F-75009 Paris (FR)**

---

(54) **Ohmmètre de sécurité pour contrôle de lignes de mise à feu électriques.**

(57) Cet ohmmètre, du type à pont de Wheatstone est alimenté en courant par une batterie de cellules photoélectriques (6), de façon à limiter intrinsèquement le courant dans la ligne de mise à feu (8).

EP 0 128 791 A1

- 1 -

Ohmmètre de sécurité pour contrôle de lignes de mise à feu électriques.

L'invention concerne un ohmmètre de sécurité pour contrôle de lignes de mise à feu électriques, utilisable notamment sur les chantiers de travaux publics, dans les carrières ou dans les mines.

Dans les exploitations de mines ou carrières par exemple où l'on utilise des explosifs, on se sert essentiellement de détonateurs à allumage électrique. La chaîne électro-pyrotechnique comprend un générateur de courant qui débite au moment voulu dans une ligne électrique comprenant un certain nombre de têtes d'amorce de détonateurs. Une tête d'amorce de quelques centigrammes enflamme une composition retardatrice, ou amorce en détonation un explosif primaire (par exemple azoture de plomb), dont la détonation amorce un explosif secondaire (du type penthrite, par exemple), en quantité voisine de 1 gramme, qui va lui-même initier en détonation les explosifs dont on recherche les effets.

Avant la mise à feu, il est important de pouvoir vérifier la continuité du circuit électrique de tir afin de garantir que le courant va bien passer dans tous les détonateurs. De plus, il est réglementaire de vérifier que tous les détonateurs sont en circuit et qu'aucun n'a été oublié. A cet effet, il faut mesurer la résistance de la ligne de mise à feu et vérifier qu'elle est conforme au calcul fait au préalable. La précision demandée dans cette mesure est telle que l'erreur absolue soit inférieure à la valeur de la résistance d'un détonateur, qui varie en général de 0,8 à 2,5 ohms, suivant le type.

Il est courant de tirer en série des volées de 100 à 200 détonateurs, et donc d'avoir à mesurer des résistances de ligne de mise à feu allant jusqu'à 500 ohms ou davantage. Pour cette mesure, on utilise des ohmmètres classiques à galvanomètre, qui présentent deux inconvénients majeurs. Tout d'abord, ils comportent un galvanomètre à aiguille qui est un appareil fragile. Ensuite, ils comprennent une source de courant à basse impédance et en cas de choc ou de fausse manoeuvre, les contacts de la source peuvent être reliés aux bornes de mesure de la résistance et déclencher la mise à feu.

Pour des raisons de sécurité, la vérification d'une ligne de mise à feu doit se faire à partir d'un poste de tir, l'ensemble du personnel étant à l'abri. Si la résistance mesurée ne correspond pas au calcul, le boutefeu doit court-circuiter la ligne, aller sur le front de tir pour la diviser en deux et revenir au poste de tir pour vérifier chaque moitié, renouveler l'opération pour la moitié présentant le défaut, et ainsi de suite jusqu'à identification du défaut. Pendant toutes ces manoeuvres, le quartier minier dans le cas d'un tir au fond d'une mine, et la zone de protection dans le cas d'un tir au jour, sont consignés, et les conséquences sur le plan économique sont sérieuses.

Un des buts de la présente invention est de prévoir un ohmmètre de séucirté réduisant le risque d'accident à un point tel que la mesure de la résistance de ligne de tir puisse être effectuée sans précaution particulière, l'opérateur pouvant rester dans la zone de tir et pouvant même vérifier directement un détonateur avant de le mettre en place.

Il est par ailleurs connu que la qualité de la mesure dans les ohmmètres classiques dépend de l'état de fraîcheur de la

- 3 -

0128791

source de courant utilisée. Des mesures faîtes avec une pile usagée par exemple, donnent des résultats faussement sécurisants.

Un autre but de l'invention est de procurer un ohmmètre dont la précision ne soit pas liée à l'état d'une source de courant.

L'invention a pour objet un ohmmètre de sécurité pour contrôle de lignes de mise à feu électriques, du type à pont de Wheatstone dans lequel la ligne de mise à feu constituer la résistance à mesurer, caractérisé en ce que ledit pont est alimenté en courant par une batterie de cellules photoélectriques de façon à limiter intrinsèquement le courant dans la ligne de mise à feu.

Selon d'autres caractéristiques de l'invention :

- les deux points de la diagonale du pont de Wheatstone alimentent chacun une entrée d'un amplificateur opérationnel dont la sortie délivre un signal logique binaire ;

- il comporte un multivibrateur délivrant des signaux alternatifs, afficheur sous la commande de l'amplificateur opérationnel, et un afficheur, les signaux de sortie du multivibrateur étant transmis à l'afficheur par l'intermédiaire du circuit de pilotage.

L'invention a également pour objet un ohmmètre de sécurité pour contrôle de lignes de mise à feu électriques, du type à pont de Wheatstone dans lequel la ligne de mise à feu constitue la résistance à mesurer et un potentiomètre la résistance d'équilibrage du pont, caractérisé en ce qu'il comporte : une batterie de cellules photoélectriques pour l'alimentation dudit pont, ladite batterie alimentant également un amplificateur opérationnel, un multivibrateur et un circuit de pilotage d'un afficheur à cristaux liquides.

L'invention est décirte ci-après avec référence au dessin annexé sur lequel on peut voir :

Figure 1 - une vue extérieure du boîtier d'un ohmmètre selon l'invention,

Figure 2 - un schéma symbolique simplifié du circuit électrique de l'ohmmètre de la figure 1.

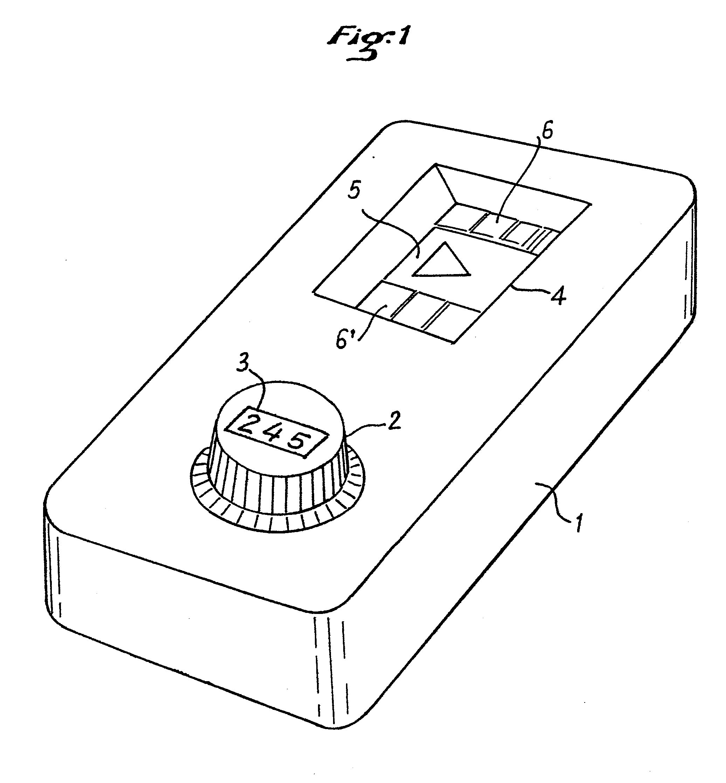

L'ohmmètre selon l'invention se présente (figure 1) sous la forme d'un boîtier 1 portant sur son bord supérieur les deux bornes de raccordement de la ligne de mise à feu à mesurer (non visibles sur le dessin), et, sur la face avant, un bouton 2 de potentiomètre à 10 tours par exemple avec affichage 3 de la valeur, et une fenêtre 4 dans laquelle sont visibles un afficheur qualitatif 5 et des cellules photoélectriques 6, 6'.

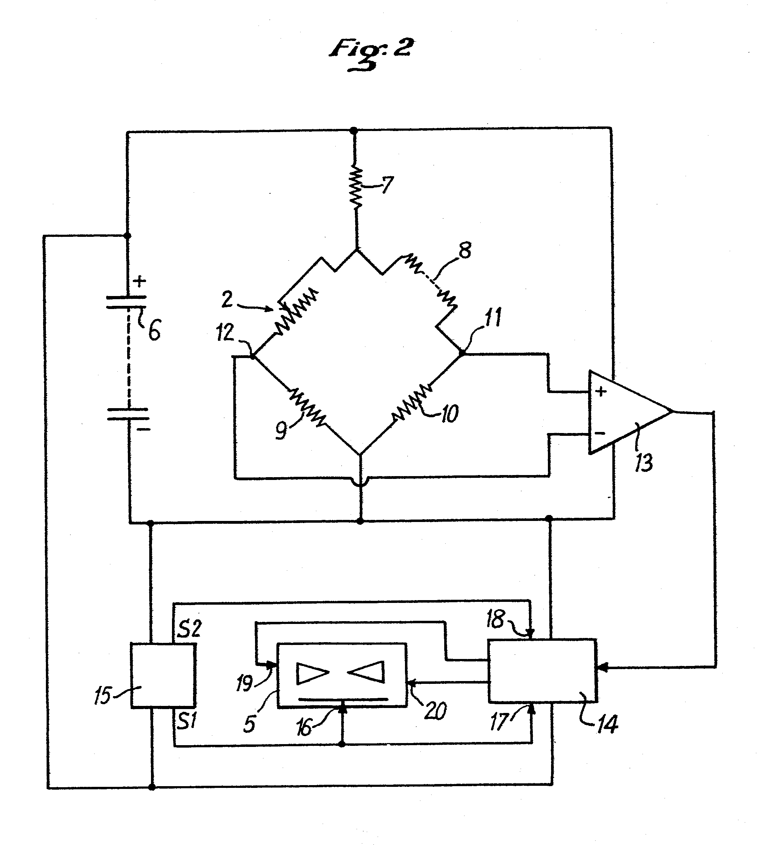

Sur la figure 2, on voit une batterie de cellules photoélectriques 6, 6', montées en série, et qui alimente par l'intermédiaire d'une résistance 7, un pont de Wheatstone. Ce pont se compose d'un potentiomètre 2, de la ligne de mise à feu 8, et de deux résistances 9 et 10. Le potentiomètre 2 est par exemple un potentiomètre à 10 tours, de 1000 ohms. L'affichage 3 de la position du potentiomètre 2 est assuré par un compteur numérique, de 0 à 999, avec une précision de 1/5 de division, correspondant à 0,2 ohm. La ligne de mise à feu 8 est constituée d'une série de résistances, une pour chaque détonateur. Les résistances 9 et 10 ont chacune une valeur d'environ 1000 ohms. Les deux points 11 et 12 de la diagonale du pont sont reliés aux deux entrées d'un amplificateur opérationnel 13 dont la sortie commande un circuit 14 de pilotage de l'afficheur 5. L'amplificateur opérationnel 13 peut fonctionner avec une tension d'alimentation de 1,5 à 5 volts par exemple.

La batterie de cellules photoélectriques 6, 6' comprend par exemple dix cellules à cristaux de silicium, dont l'intérêt majeur est d'avoir une tension aux bornes intrinsèquement limitée à 0,45 V/cm² quel que soit l'éclairement des cellules. Du fait de cette limitation de tension, l'intensité du courant qui passe dans le pont est de quelques milliampères.

Dans l'exemple représenté, l'intensité de court-circuit de la batterie de cellules ne peut pas dépasser 20 mA. Les détonateurs les plus sensibles sont définis comme ne pouvant être amorcés par un courant inférieur à 350 mA, quel que soit le temps de passage de ce courant. Si ces détonateurs sont placés dans la ligne de mise à feu 8, ils ne pourront recevoir que 2 à 3 mA, et dans l'hypothèse d'une fausse manoeuvre, un détonateur branché directement sur la batterie de cellules photoélectriques ne recevrait qu'un courant de 10 mA, ce qui est très loin du seuil de danger. C'est pourquoi on peut contrôler les détonateurs directement sur la ligne de mise à feu, sans précautions particulières, avec l'ohmmètre selon l'invention.

L'amplificateur opérationnel est à gain très élevé, et il fonctionne en sortie binaire. Lorsque le courant dans la diagonale du pont est dans un sens, le signal de sortie de l'amplificateur opérationnel 13 est de type 1, lorsque le courant passe dans l'autre sens, le signal de sortie est de type 0. Ce signal commande le circuit logique 14 de pilotage de l'afficheur 5.

En dehors du pont de mesure et de l'amplificateur opérationnel, la batterie de cellules photoélectriques alimente un multivibrateur 15 et le circuit de pilotage 14, en tension continue de quelques volts.

Le multivibrateur 15 élabore des signaux alternatifs à une fréquence de 50 Hz environ, pour exciter l'afficheur à cristaux liquides 5. Cette excitation en alternatif est nécessaire pour garantir la durée de vie de ce type d'afficheur. Aux sorties du multivibrateur 15, on dispose ainsi de deux signaux S1 et S2 en opposition de phase.

Le signal S1 est appliqué directement à la base 16 de l'afficheur 5 et à une entrée 17 du circuit 14. Le signal S2 est appliqué directement à une autre entrée 18 du circuit 14. Les deux sorties du circuit 14 sont appliquées respectivement aux entrées 19 et 20 de l'afficheur 5.

Lorsque le signal de sortie de l'amplificateur opérationnel est 1, le circuit 14 de pilotage de l'afficheur 5 applique à l'entrée 19 un signal S2 par exemple et à l'entrée 20 un signal S1. La base 16 étant alimentée par un signal S1, seule la flèche de gauche est visible car alimentée en opposition de phase par rapport à la base 16.

Lorsque le signal de sortie de l'amplificateur opérationnel est 0, le circuit de pilotage 14 applique S1 à l'entrée 19 et S2 à l'entrée 20 de l'afficheur5.La flèche de droite est alors seule visible.

La flèche visible de l'afficheur 5 indique le sens de rotation à appliquer au potentiomètre 2 pour aller vers l'équilibre du pont afin de mesurer la résistance de la ligne de tir. Lorsque, en tournant le bouton du potentiomètre 2, on franchit le point d'équilibre du pont, le sens du courant s'inverse entre les points 11 et 12, la sortie de l'amplificateur opérationnel bascule, et le circuit 14 de pilotage inverse les signaux qu'il adresse aux entrées 19 et 20 de l'afficheur. La flèche visible de l'afficheur 5 permute alors. En revenant en arrière avec le potentiomètre, on peut arriver à définir avec une assez bonne précision le point d'équilibre du pont et la valeur correspondante de la résistance de la ligne de mise à feu. Au point d'équilibre, cette valeur est déterminée avec une erreur inférieure à 1 ohm. L'utilisation d'une méthode de zéro permet de s'affranchir de la stabilité en tension de la batterie de cellules photoélectriques.

L'appareil est construit de telle façon que si la tension d'alimentation est trop faible (cellules photoélectriques insuffisamment éclairées) l'amplificateur opérationnel ne peut
pas fonctionner et l'afficheur à cristaux liquides ne donne
plus de signaux visibles. Dans un tel cas, l'afficheur ne peut
fournir une information erronée.

L'éclairement nécessaire au fonctionnement de l'appareil est
fourni par une lampe de casque de mineur par exemple pour les
travaux en souterrain, ou de nuit, ou par la lumière du jour
pour les travaux en surface de jour.

On peut avantageusement disposer les éléments du circuit électronique 13, 14 et 15 notamment, sous forme de circuits imprimés, noyés dans une résine avec toutes les parties fixes de
l'appareil, de façon à le rendre totalement étanche.

Dans le mode de réalisation représenté, les cellules photoélectriques ont été groupées autour de l'afficheur 5 à cristaux liquides. En effet, lorsque l'éclairement des cellules
est insuffisant, l'afficheur ne peut présenter de flèche éclairée. Comme l'opérateur a tendance à regarder l'afficheur
au moment de la mesure, il oriente automatiquement sa lampe
vers les cellules photoélectriques qui bénéficient ainsi de
l'éclairement maximal. Ainsi, lorsque l'afficheur présente
une flèche visible, il est en état de marche. Cette particularité de l'appareil fait qu'il n'est pas nécessaire d'avoir
un bouton de test comme sur les autres ohmmètres, afin de
vérifier au préalable, le bon fonctionnement de l'appreil
lui-même.

On doit remarquer que l'appareil selon l'unvention effectue
à la fois le test de continuité de la ligne de mise à feu et
la mesure de la résistance électrique de cette ligne.

Au sujet de cette mesure, si l'appareil peut la faire, car
l'éclairement est suffisant, cette mesure est juste, car
elle ne dépend pas du niveau de tension d'une source de courant autonome mais d'un seuil d'éclairement.

Selon l'invention, l'ohmmètre proposé est sûr, fiable, et ne peut pas, par construction et par la nature de ses cellules photoélectriques, fournir une intensité de courant dangereuse.

0128791

## Revendications de brevet

1. - Ohmmètre de sécurité pour contrôle de lignes de mise à feu électriques, du type à pont de Wheatstone dans lequel la ligne de mise à feu constitue la résistance à mesurer, ledit pont étant alimenté en courant par des cellules photoélectriques de façon à limiter intrinsèquement le courant dans la ligne de mise à feu, caractérisé en ce que les deux points (11, 12) de la diagonale du pont de Wheatstone alimentent chacun une entrée d'un amplificateur opérationnel (13) dont la sortie délivre un signal logique binaire.

2. - Ohmmètre selon la revendication 1, caractérisé en ce qu'il comporte un multivibrateur (15) délivrant des signaux alternatifs, un circuit (14) de pilotage d'un afficheur (5) sous la commande de l'amplificateur opérationnel (13), et un afficheur (5), les signaux de sortie du multivibrateur (15) étant transmis à l'afficheur (5) par l'intermédiaire du circuit de pilotage (14).

3. - Ohmmètre de sécurité pour contrôle de lignes de mise à feu électriques, du type à pont de Wheatstone dans lequel la ligne de mise à feu constitue la résistance (8) à mesurer et un potentiomètre (2) la résistance d'équilibre du pont, caractérisé en ce qu'il comporte : une batterie de cellules photoélectriques (6, 6') pour l'alimentation dudit pont, ladite batterie alimentant également un amplificateur opérationnel (13), un multivibrateur (15) et un circuit de pilotage (14) d'un afficheur (2) à cristaux liquides.

*Fig:1*

## Fig. 2

Office européen
des brevets

**RAPPORT DE RECHERCHE EUROPEENNE**

0128791

Numéro de la demande

EP 84 40 0963

## DOCUMENTS CONSIDERES COMME PERTINENTS

| Categorie | Citation du document avec indication, en cas de besoin, des parties pertinentes | Revendication concernée | CLASSEMENT DE LA DEMANDE (Int. Cl. 3) |
|---|---|---|---|
| A | FR-A-2 034 332 (G. VERANE)<br>* Figure 1; revendication 1 *<br><br>----- | 1,3 | F 42 D 1/04<br>G 01 R 17/10 |

**DOMAINES TECHNIQUES RECHERCHES (Int. Cl. 3)**

F 42 D
G 01 R

Le présent rapport de recherche a été établi pour toutes les revendications

| Lieu de la recherche | Date d'achèvement de la recherche | Examinateur |
|---|---|---|
| LA HAYE | 13-07-1984 | MIELKE W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82